# EUROPEAN PATENT SPECIFICATION

(11) **EP 4 115 764 B1**
(45) Date of publication and mention of the grant of the patent: **08.10.2025**
(21) Application number: 22182357.8
(22) Date of filing: 30.06.2022
(51) Int. Cl.: A44C 27/00, C23C 14/00, C23C 14/02, C23C 14/16, C23C 14/58, C23C 16/00, C23C 16/02, C23C 16/06, C23C 28/00

(54) **NOBLE METAL MEMBER CAPABLE OF EXPRESSING VIVID COLORS, AND METHOD OF COLORING SURFACE OF NOBLE METAL MEMBER**
EDELMETALLELEMENT, DAS IN DER LAGE IST, LEBHAFTE FARBEN AUSZUDRÜCKEN, UND VERFAHREN ZUM FÄRBEN DER OBERFLÄCHE EINES EDELMETALLELEMENTS
ÉLÉMENT DE MÉTAL NOBLE CAPABLE D'EXPRIMER DES COULEURS VIVES, ET PROCÉDÉ DE COLORATION DE SURFACE D'UN ÉLÉMENT DE MÉTAL NOBLE

(30) Priority: 06.07.2021 KR 20210088627
(43) Date of publication of application: 11.01.2023
(73) Proprietor: Korea Institute of Science and Technology, Seoul 02792 (KR)
(72) Inventor: BYUN, Ji Young, 02792 Seoul (KR); RAHMAN, MD Abdur, 02792 Seoul (KR); KIM, Sang Hoon, 02792 Seoul (KR); CHO, So Hye, 02792 Seoul (KR); LEE, Seung Yong, 02792 Seoul (KR); KO, Hyungduk, 02792 Seoul (KR); CHOI, Sung Lim, 02792 Seoul (KR); KIM, Dong Kyu, 02792 Seoul (KR); CHOI, Kwang-deok, 02792 Seoul (KR); BAEK, Inuk, 02792 Seoul (KR); KIM, Yun Hee, 11638 Uijeongbu-si (KR)
(74) Representative: Taor, Simon Edward William

(56) References cited:
- KR-A- 20200 118 703
- US-A1- 2020 310 016

## Description

### CROSS-REFERENCE TO RELATED PATENT APPLICATION

This application claims the benefit of Korean Patent Application No. 10-2021-0088627, filed on July 6, 2021, in the Korean Intellectual Property Office.

### BACKGROUND

### 1. Field

The present invention relates to a noble metal member capable of expressing vivid colors, and a method of coloring the surface of the noble metal member and, more particularly, to a noble metal member capable of expressing vivid and various colors by applying a color control layer on the surface of the noble metal member, and a method of coloring the surface of the noble metal member to express vivid and various colors.

### 2. Description of the Related Art

Noble metals such as gold (Au), platinum (Pt), rhodium (Rh), and silver (Ag) are materials broadly used for jewelry, accessories, and handicrafts. Pt and Rh are used as high-priced jewelry materials due to their white metallic luster and high hardness. Ag is employed as an accessory or handicraft material due to its white metallic luster, relatively low price, and easy processability. Au is the most broadly used noble metal material due to its high corrosion resistance, easy processability, and high liquidity.

Particularly, Au, which exhibits a golden metallic luster, has become an attractive noble metal that everyone wants to own as a symbol of nobility and wealth. Moreover, to further increase the rarity of Au and to further boast of nobility, authority, and wealth, efforts have been made to change Au to colors other than golden yellow. As a result, Au alloys of various colors such as pink, blue, red, green, brown, and black have become known.

A representative example thereof is an AuAl₂ intermetallic compound known as pink gold. The AuAl₂ intermetallic compound is an 18K alloy having an Au content less than or equal to 79 wt%. Meanwhile, AuIn₂ (having an Au content less than or equal to 46 wt%) and AuGa₂ (having an Au content less than or equal to 58.5 wt%) intermetallic compounds are blue, and an AuCu (having an Au content less than or equal to 50 wt%) intermetallic compound is red.

These intermetallic compounds may be easily broken due to their high brittleness, and exhibit multiple colors together instead of a single color unless carefully control its composition and cast to form a shape. KR20200118703A discloses a metal member. US2020/0310016 discloses a coloring pattern structure.

### SUMMARY

The present invention provides a noble metal member capable of expressing vivid and various colors by applying a color control layer on the surface of the noble metal member through a simple process, and a method of coloring the surface of the noble metal member. However, the scope of the present invention is not limited thereto.

According to an aspect of the present invention, there is provided a noble metal member capable of expressing vivid colors according to claim 1.

According to another aspect of the present invention, there is provided a method of coloring a surface of a noble metal member according to claim 6.

According to another aspect of the present invention, there is provided a method of coloring a surface of a noble metal member according to claim 8.

### BRIEF DESCRIPTION OF THE DRAWINGS

The above and other features and advantages of the present invention will become more apparent by describing in detail embodiments thereof with reference to the attached drawings in which:
FIGS. 1 to 3 are cross-sectional views of noble metal members capable of expressing vivid colors, according to embodiments of the present invention; and
FIGS. 4 to 10 are images showing surface colors of noble metal members according to test examples of the present invention.

### DETAILED DESCRIPTION

Hereinafter, the present invention will be described in detail by explaining embodiments of the invention with reference to the attached drawings. The invention may, however, be embodied in many different forms and should not be construed as being limited to the embodiments set forth herein; rather, these embodiments are provided so that this disclosure will be thorough and complete, and will fully convey the concept of the invention to one of ordinary skill in the art, as defined by the claims.

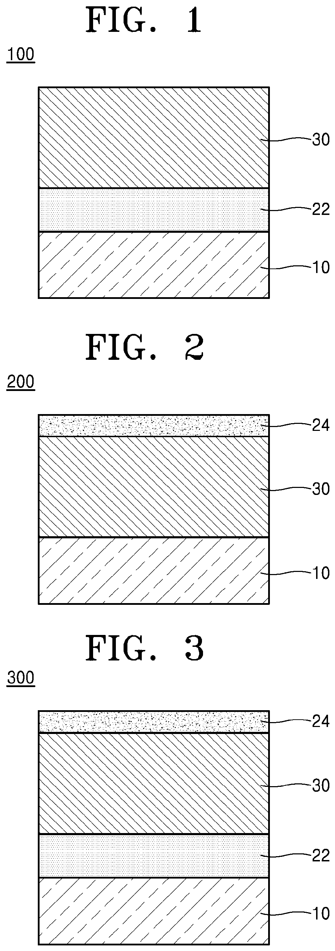

A noble metal member capable of expressing vivid colors, according to an embodiment of the present invention, may include a noble metal substrate, a dielectric layer provided on the noble metal substrate, and a compound layer containing aluminum (Al) and provided on at least one surface of the dielectric layer. Herein, various colors may be expressed based on positions and thicknesses of the dielectric layer and the compound layer containing Al. For example, the compound layer may be interposed between the noble metal substrate and the dielectric layer, or be provided on the dielectric layer. Alternatively, the compound layer may be provided on lower and upper surfaces of the dielectric layer. A detailed description thereof will now be provided with reference to FIGS. 1 to 3.

FIGS. 1 to 3 are cross-sectional views of noble metal members 100, 200, and 300 capable of expressing vivid colors, according to embodiments of the present invention.

Referring to FIG. 1, the noble metal member 100 according to an embodiment of the present invention includes a structure which a noble metal substrate 10, a compound layer 22 containing Al, and a dielectric layer 30 are sequentially stacked on one another. The noble metal substrate 10 may use a noble metal, e.g., gold (Au), platinum (Pt), rhodium (Rh), or silver (Ag).

The compound layer 22 containing Al may be provided on the noble metal substrate 10. The compound layer 22 containing Al includes an aluminide intermetallic compound, e.g., AuAl₂, AuAl, PtAl₂, PtAl, or Pt₂Al. The compound layer 22 may have a thickness greater than or equal to 50 nm to exhibit unique optical properties (e.g., reflectivity) thereof.

When the thickness of the compound layer 22 is less than 50 nm, because a part of light is transmitted through the compound layer 22 to cause interference with the noble metal substrate 10, an effect of the compound layer 22 may be reduced and a vivid color may not be expressed. Although the compound layer 22 may have a thickness greater than or equal to 50 nm for the above reason, a smaller thickness of the compound layer 22 is better from an economic perspective and is recommended due to a high brittleness of the compound layer 22. Accordingly, it is best to control the thickness of the compound layer 22 in a range of 50 nm to 300 nm in consideration of convenience of process control, but the thickness of the compound layer 22 may be controlled to be greater than or equal to 300 nm when a device having a very high deposition rate is used.

The compound layer 22 may be formed using any one selected from among physical vapor deposition (PVD), chemical vapor deposition (CVD), and atomic layer deposition (ALD), or using various other thin film coating methods. The above-mentioned thin film deposition methods are already known, and thus a detailed description thereof is not provided herein.

Thereafter, the dielectric layer 30 may be provided on the compound layer 22. The dielectric layer 30 may be formed using the same thin film deposition method used to form the compound layer 22. The dielectric layer 30 may include, for example, WO₃, AIN, TiO₂, Al₂O₃, MgO, SiO₂, Si₃N₄, or indium tin oxide (ITO), and have a thickness ranging from 30 nm to 400 nm. Herein, when the thickness of the dielectric layer 30 is less than 30 nm, vivid colors may not appear.

On the other hand, various colors may be expressed by increasing the thickness of the dielectric layer 30 from 30 nm, and most desired colors may be expressed when the thickness of the dielectric layer 30 is in a range less than or equal to 400 nm. Therefore, the thickness of the dielectric layer 30 may be controlled to be 30 nm to 400 nm in consideration of an economical aspect.

Although the compound layer 22 has a high brittleness, the compound layer 22 is provided in the form of a thin film having a thickness less than or equal to 300 nm, and thus a problem of brittleness does not occur. Because the thin film deposition methods are used, an intermetallic compound layer having a uniform composition may be formed on the entire surface of the noble metal substrate 10. In addition, the aluminide intermetallic compound of the compound layer 22 includes a highly reactive element, and thus may increase adhesion with the noble metal substrate 10 and the dielectric layer 30.

As another example, referring to FIG. 2, the noble metal member 200 includes a structure in which the noble metal substrate 10, the dielectric layer 30 and a compound layer 24 containing Al are sequentially stacked on one another. A detailed description of the components already described above is not provided below.

The dielectric layer 30 may be provided on the noble metal substrate 10, and then the compound layer 24 containing Al may be provided on the dielectric layer 30. The dielectric layer 30 and the compound layer 24 may be formed using one of the above-described thin film deposition methods. Herein, the compound layer 24 uses the same material as the compound layer 22 illustrated in FIG. 1, but thickness ranges thereof are different.

When the compound layer 24 provided on the dielectric layer 30 has a thickness greater than or equal to 50 nm, light toward the dielectric layer 30 is blocked and thus color expression based on interference is not enabled. Therefore, the compound layer 24 on the dielectric layer 30 needs to be controlled to a thickness less than 50 nm, and a suitable thickness range thereof may be 5 nm to 40 nm. The type, brightness, or saturation of a color may be controlled based on a change in the thickness of the compound layer 24 within the above-mentioned range.

As still another example, referring to FIG. 3, the noble metal member 300 includes a structure in which the noble metal substrate 10, the compound layer 22 containing Al, the dielectric layer 30, and the compound layer 24 containing Al are sequentially stacked on one another. A detailed description of the components already described above is not provided below.

Initially, the compound layer 22 containing Al may be provided on the noble metal substrate 10 like the noble metal member 100 illustrated in FIG. 1. Thereafter, the dielectric layer 30 may be provided on the compound layer 22, and then the compound layer 24 containing Al may be provided on the dielectric layer 30. The compound layer 22, the dielectric layer 30, and the compound layer 24 may be formed using one of the above-described thin film deposition methods.

The compound layer 22 provided under the dielectric layer 30 and the compound layer 24 provided on the dielectric layer 30 may use the same material, or use different materials in some cases. A thickness of the compound layer 22 provided under the dielectric layer 30 may be greater than or equal to 50 nm, and be controlled in a range of 50 nm to 300 nm to provide convenience of process. The compound layer 24 provided on the dielectric layer 30 is used to control an interference effect, and a thickness range thereof may be 5 nm to 40 nm.

Test examples of the present invention will now be described. However, the following test examples are merely for better understanding of the present invention, and the present invention is not limited thereto.

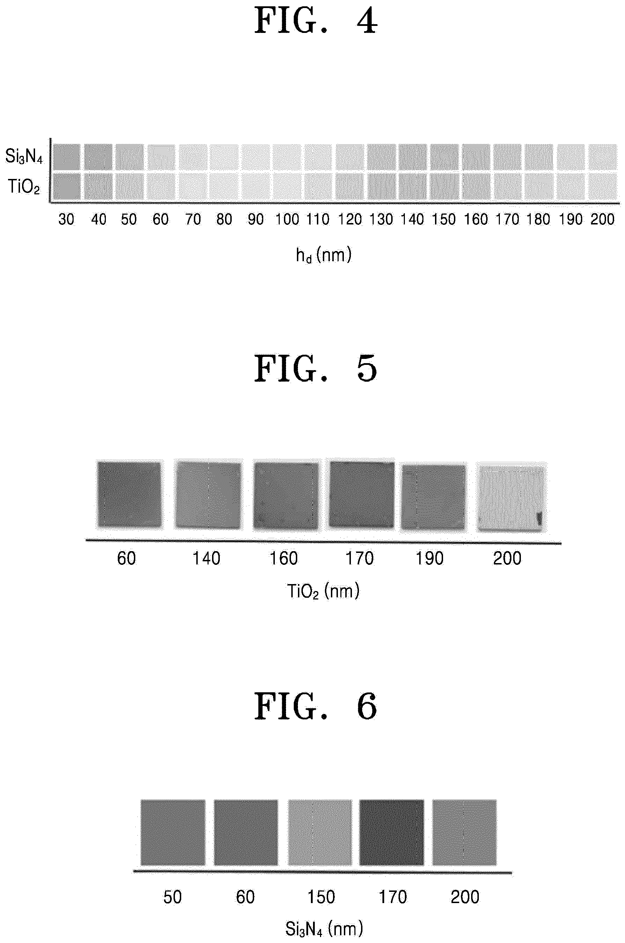

FIGS. 4 to 10 are images showing surface colors of noble metal members according to test examples of the present invention. Color changes of the noble metal members under various test example conditions will now be described.

As a test example of the present invention, a Si₃N₄ dielectric layer and a TiO₂ dielectric layer were formed to have various thicknesses on an Au substrate and surface color changes of the Au substrate were observed as shown in FIG. 4.

In addition, an AuAl₂ compound layer (containing 37 at% of Au) having a thickness of 50 nm was formed on an Au substrate, a Si₃N₄ dielectric layer and a TiO₂ dielectric layer were formed to have various thicknesses on the compound layer, and surface color changes of the Au substrate were observed as shown in FIGS. 5 and 6. Herein, the Si₃N₄ dielectric layer was formed using plasma-enhanced chemical vapor deposition (PECVD), and the TiO₂ dielectric layer was formed using reactive sputtering.

Initially, referring to FIG. 4, when no AuAl₂ compound layer is formed, the color of the entire sample is dominated by the yellow color of Au itself and thus the color changes of the sample are not significant even when the thickness of the dielectric layer is changed. On the other hand, the AuAl₂ compound layer itself has a pink color to reduce the reflectivity of the yellow color area and thus, as shown in FIGS. 5 and 6, significant color changes are exhibited based on the change in the thickness of the dielectric layer.

Meanwhile, although not shown in the drawings, even when a SiO₂ layer having a thickness of 400 nm was further coated on the Si₃N₄ or TiO₂ dielectric layer, no significant color changes were observed. This shows that, when necessary, a low-refractivity layer such as SiO₂ may be coated on the top to protect the Si₃N₄ or TiO₂ dielectric layer used as a color layer.

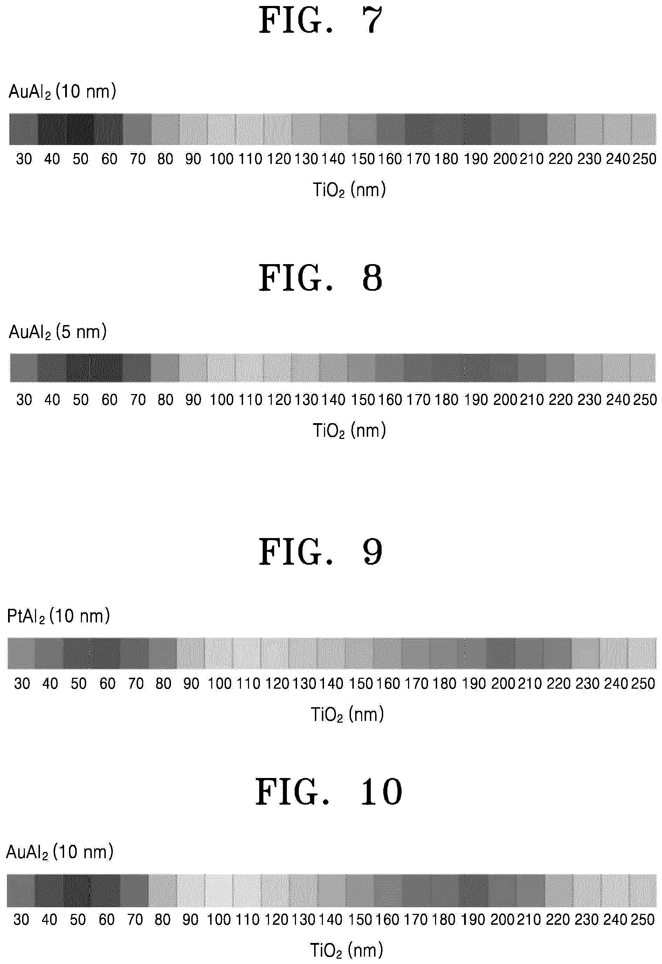

As another test example of the present invention, an AuAl₂ compound layer having a thickness of 100 nm was formed on an Au substrate, and a TiO₂ dielectric layer was formed to have various thicknesses on the compound layer. Thereafter, an AuAl₂ compound layer having thicknesses of 10 nm and 5 nm was formed on the dielectric layer and surface color changes of the Au substrate were observed as shown in FIGS. 7 and 8.

In addition, a PtAl₂ compound layer having a thickness of 100 nm was formed on an Au substrate, and a TiO₂ dielectric layer was formed to have various thicknesses on the compound layer. Thereafter, a PtAl₂ compound layer having a thickness of 10 nm was formed on the dielectric layer and surface color changes of the Au substrate were observed as shown in FIG. 9.

Referring to FIGS. 7 and 8, when the AuAl₂ compound layer having thicknesses of 10 nm and 5 nm is deposited on the TiO₂ dielectric layer, more vivid colors are expressed compared to the case in which no AuAl₂ compound layer is formed as shown in FIG. 4.

Referring to FIG. 9, even when the PtAl₂ compound layer is used, color changes similar to those of the case in which the AuAl₂ compound layer is used are exhibited, and colors brighter than those shown in FIG. 7 are expressed. This shows that various colors may be expressed by changing a material used for a stacked structure of a color control layer applied to the noble metal member.

Meanwhile, although not shown in the drawings, even when a SiO₂ layer having a thickness of 200 nm to 1000 nm was further coated on the AuAl₂ compound layer formed on the dielectric layer, no significant color changes were observed. This shows that, when necessary, a low-refractivity layer such as SiO₂ may be coated on the top to protect the Si₃N₄ or TiO₂ dielectric layer used as a color layer.

As still another test example of the present invention, a TiO₂ dielectric layer with various thicknesses was formed on an Au substrate, an AuAl₂ compound layer having a thickness of 10 nm was formed on the dielectric layer, and surface color changes of the Au substrate were observed as shown in FIG. 10.

Referring to FIG. 10, compared to the noble metal member sample including no AuAl₂ compound layer on the top as shown in FIG. 4, very significant color changes are exhibited when the AuAl₂ compound layer is formed on the top.

As described above, it is shown that, when a low-reflectivity intermetallic compound layer such as AuAl₂ is used, an interference effect of light may be increased and thus a vivid color may be expressed on the surface of a noble metal substrate. In this case, various color changes may be induced based on the thickness and type of the intermetallic compound layer and the thickness and type of a dielectric layer, and a color to be used may be controlled at this time by the selection of a designer. Furthermore, because the intermetallic compound layer partially includes a noble metal, when handicrafts are made, the handicrafts may entirely include the noble metal and thus more precious products may be provided to customers.

According to the above-described method of the present invention, the surface of a noble metal member may be controlled to vivid and various colors, and thus a noble metal member capable of expressing various colors may be provided.

While the present invention has been particularly shown and described with reference to embodiments thereof, it will be understood by one of ordinary skill in the art that various changes in form and details may be made therein without departing from the scope of the present invention as defined by the following claims.

## Claims

1. A noble metal member (100, 200, 300) capable of expressing vivid colors, the noble metal member comprising:
a noble metal substrate (10);
a dielectric layer (30) provided on the noble metal substrate (10); and
a compound layer (22, 24) containing aluminum (Al) and provided on at least one surface of the dielectric layer (30),
**characterized in that** the compound layer (22, 24) comprises an aluminide intermetallic compound, or
wherein the compound layer (22, 24) comprises AuAl₂, AuAl, PtAl₂, PtAl, or Pt₂Al.

2. The noble metal member of claim 1, wherein the compound layer (22) is interposed between the noble metal substrate (10) and the dielectric layer (30), or
wherein the compound layer (24) is provided on the dielectric layer (30).

3. The noble metal member of claim 1, wherein the compound layer (22, 24) is provided on lower and upper surfaces of the dielectric layer (30).

4. The noble metal member of claim 2, wherein the compound layer (22) has a thickness ranging from 50 nm to 300 nm when the compound layer (22) is interposed between the noble metal substrate (10) and the dielectric layer (30); or
wherein the compound layer (24) has a thickness ranging from 5 nm to 40 nm when the compound layer (24) is provided on the dielectric layer (30).

5. The noble metal member of claim 1, wherein the dielectric layer (30) comprises WO₃, AlN, TiO₂, Al₂O₃, MgO, SiO₂, Si₃N₄, or indium tin oxide (ITO); and/or
wherein the dielectric layer (30) has a thickness ranging from 30 nm to 400 nm.

6. A method of coloring a surface of a noble metal member, the method comprising:
forming, on a noble metal substrate (10), a compound layer (22) containing aluminum (Al); and
forming a dielectric layer (30) on the compound layer (22),
**characterized in that** the compound layer (22, 24) comprises an aluminide intermetallic compound, or
wherein the compound layer (22, 24) comprises AuAl₂, AuAl, PtAl₂, PtAl, or Pt₂Al.

7. The method of claim 6, further comprising forming, on the dielectric layer (30), a compound layer (24) containing Al.

8. A method of coloring a surface of a noble metal member, the method comprising:
forming a dielectric layer (30) on a noble metal substrate (10); and
forming, on the dielectric layer (30), a compound layer (24) containing aluminum (Al),
**characterized in that** the compound layer (22, 24) comprises an aluminide intermetallic compound, or
wherein the compound layer (22, 24) comprises AuAl₂, AuAl, PtAl₂, PtAl, or Pt₂Al.

9. The method of any one of claims 6 to 8, wherein the forming of the compound layer (22, 24) is performed using any one selected from among physical vapor deposition (PVD), chemical vapor deposition (CVD), and atomic layer deposition (ALD).

10. The method of claim 9, wherein the compound layer (22) has a thickness ranging from 50 nm to 300 nm when the compound layer (22) is interposed between the noble metal substrate (10) and the dielectric layer (30); or
wherein the compound layer (24) has a thickness ranging from 5 nm to 40 nm when the compound layer (24) is provided on the dielectric layer (30).

11. The method of any one of claims 6 to 10, wherein the dielectric layer (30) comprises WO₃, AlN, TiO₂, Al₂O₃, MgO, SiO₂, Si₃N₄, or indium tin oxide (ITO); and/or
wherein the dielectric layer has a thickness ranging from 30 nm to 400 nm.

## Patentansprüche

1. Edelmetallelement (100, 200, 300), das in der Lage ist, lebhafte Farben auszudrücken, wobei das Edelmetallelement Folgendes umfasst:
ein Edelmetallsubstrat (10);
eine dielektrische Schicht (30), die auf dem Edelmetallsubstrat (10) bereitgestellt ist; und
eine Verbindungsschicht (22, 24), die Aluminium (Al) enthält und auf zumindest einer Oberfläche der dielektrischen Schicht (30) bereitgestellt ist,
**dadurch gekennzeichnet, dass** die Verbindungsschicht (22, 24) eine intermetallische Aluminidverbindung umfasst, oder
wobei die Verbindungsschicht (22, 24) AuAl₂, AuAl, PtAl₂, PtAl oder Pt₂Al umfasst.

2. Edelmetallelement nach Anspruch 1, wobei die Verbindungsschicht (22) zwischen dem Edelmetallsubstrat (10) und der dielektrischen Schicht (30) eingefügt ist, oder
wobei die Verbindungsschicht (24) auf der dielektrischen Schicht (30) bereitgestellt ist.

3. Edelmetallelement nach Anspruch 1, wobei die Verbindungsschicht (22, 24) auf unteren und oberen Oberflächen der dielektrischen Schicht (30) bereitgestellt ist.

4. Edelmetallelement nach Anspruch 2, wobei die Verbindungsschicht (22) eine Dicke aufweist, die von 50 nm bis 300 nm reicht, wenn die Verbindungsschicht (22) zwischen dem Edelmetallsubstrat (10) und der dielektrischen Schicht (30) eingefügt ist; oder
wobei die Verbindungsschicht (24) eine Dicke aufweist, die von 5 nm bis 40 nm reicht, wenn die Verbindungsschicht (24) auf der dielektrischen Schicht (30) bereitgestellt ist.

5. Edelmetallelement nach Anspruch 1, wobei die dielektrische Schicht (30) WO₃, AlN, TiO₂, Al₂O₃, MgO, SiO₂, Si₃N₄ oder Indiumzinnoxid (ITO) umfasst; und/oder
wobei die dielektrische Schicht (30) eine Dicke aufweist, die von 30 nm bis 400 nm reicht.

6. Verfahren zum Färben einer Oberfläche eines Edelmetallelements, wobei das Verfahren Folgendes umfasst:
Bilden, auf einem Edelmetallsubstrat (10), einer Verbindungsschicht (22), die Aluminium (Al) enthält; und
Bilden einer dielektrischen Schicht (30) auf der Verbindungsschicht (22),
**dadurch gekennzeichnet, dass** die Verbindungsschicht (22, 24) eine intermetallische Aluminidverbindung umfasst, oder
wobei die Verbindungsschicht (22, 24) AuAl₂, AuAl, PtAl₂, PtAl oder Pt₂Al umfasst.

7. Verfahren nach Anspruch 6, ferner umfassend Bilden, auf der dielektrischen Schicht (30), einer Verbindungsschicht (24), die Al enthält.

8. Verfahren zum Färben einer Oberfläche eines Edelmetallelements, wobei das Verfahren Folgendes umfasst:
Bilden einer dielektrischen Schicht (30) auf einem Edelmetallsubstrat (10); und
Bilden, auf der dielektrischen Schicht (30), einer Verbindungsschicht (24), die Aluminium (Al) enthält,
**dadurch gekennzeichnet, dass** die Verbindungsschicht (22, 24) eine intermetallische Aluminidverbindung umfasst, oder
wobei die Verbindungsschicht (22, 24) AuAl₂, AuAl, PtAl₂, PtAl oder Pt₂Al umfasst.

9. Verfahren nach einem der Ansprüche 6 bis 8, wobei das Bilden der Verbindungsschicht (22, 24) unter Verwendung eines beliebigen ausgewählt aus physikalischer Dampfabscheidung (PVD), chemischer Dampfabscheidung (CVD) und Atomschichtabscheidung (ALD) durchgeführt wird.

10. Verfahren nach Anspruch 9, wobei die Verbindungsschicht (22) eine Dicke aufweist, die von 50 nm bis 300 nm reicht, wenn die Verbindungsschicht (22) zwischen dem Edelmetallsubstrat (10) und der dielektrischen Schicht (30) eingefügt ist; oder
wobei die Verbindungsschicht (24) eine Dicke aufweist, die von 5 nm bis 40 nm reicht, wenn die Verbindungsschicht (24) auf der dielektrischen Schicht (30) bereitgestellt ist.

11. Verfahren nach einem der Ansprüche 6 bis 10, wobei die dielektrische Schicht (30) WO₃, AlN, TiO₂, Al₂O₃, MgO, SiO₂, Si₃N₄ oder Indiumzinnoxid (ITO) umfasst; und/oder
wobei die dielektrische Schicht eine Dicke aufweist, die von 30 nm bis 400 nm reicht.

## Revendications

1. Élément en métal noble (100, 200, 300) capable d'exprimer des couleurs vives, l'élément en métal noble comprenant :
un substrat en métal noble (10) ;
une couche diélectrique (30) prévue sur le substrat en métal noble (10) ; et
une couche de composé (22, 24) contenant de l'aluminium (Al) et prévue sur au moins une surface de la couche diélectrique (30),
**caractérisé en ce que** la couche de composé (22, 24) comprend un composé intermétallique d'aluminure, ou
dans lequel la couche de composé (22, 24) comprend AuAl₂, AuAl, PtAl₂, PtAl ou Pt₂Al.

2. Élément en métal noble de la revendication 1, dans lequel la couche de composé (22) est interposée entre le substrat en métal noble (10) et la couche diélectrique (30), ou dans lequel la couche de composé (24) est prévue sur la couche diélectrique (30).

3. Élément en métal noble de la revendication 1, dans lequel la couche de composé (22, 24) est prévue sur les surfaces inférieure et supérieure de la couche diélectrique (30).

4. Élément en métal noble de la revendication 2, dans lequel la couche de composé (22) a une épaisseur allant de 50 nm à 300 nm lorsque la couche de composé (22) est interposée entre le substrat en métal noble (10) et la couche diélectrique (30) ; ou
dans lequel la couche de composé (24) a une épaisseur allant de 5 nm à 40 nm lorsque la couche de composé (24) est prévue sur la couche diélectrique (30).

5. Élément en métal noble de la revendication 1, dans lequel la couche diélectrique (30) comprend WO₃, AlN, TiO₂, Al₂O₃, MgO, SiO₂, Si₃N₄ ou de l'oxyde d'indium et d'étain (ITO) ; et/ou dans lequel la couche diélectrique (30) a une épaisseur allant de 30 nm à 400 nm.

6. Procédé de coloration d'une surface d'un élément en métal noble, le procédé comprenant :
la formation, sur un substrat en métal noble (10), d'une couche de composé (22) contenant de l'aluminium (Al) ; et
la formation d'une couche diélectrique (30) sur la couche de composé (22),
**caractérisé en ce que** la couche de composé (22, 24) comprend un composé intermétallique d'aluminure, ou
dans lequel la couche de composé (22, 24) comprend AuAl₂, AuAl, PtAl₂, PtAl ou Pt₂Al.

7. Procédé de la revendication 6, comprenant en outre la formation, sur la couche diélectrique (30), d'une couche de composé (24) contenant Al.

8. Procédé de coloration d'une surface d'un élément en métal noble, le procédé comprenant :
la formation d'une couche diélectrique (30) sur un substrat en métal noble (10) ; et
la formation, sur la couche diélectrique (30), d'une couche de composé (24) contenant de l'aluminium (Al),
**caractérisé en ce que** la couche de composé (22, 24) comprend un composé intermétallique d'aluminure, ou
dans lequel la couche de composé (22, 24) comprend AuAl₂, AuAl, PtAl₂, PtAl, ou Pt₂Al.

9. Procédé de l'une quelconque des revendications 6 à 8, ladite formation de la couche de composé (22, 24) étant réalisée par un moyen quelconque sélectionné parmi le dépôt physique en phase vapeur (PVD), le dépôt chimique en phase vapeur (CVD) et le dépôt de couche atomique (ALD).

10. Procédé de la revendication 9, dans lequel la couche de composé (22) a une épaisseur allant de 50 nm à 300 nm lorsque la couche de composé (22) est interposée entre le substrat en métal noble (10) et la couche diélectrique (30) ; ou
dans lequel la couche de composé (24) a une épaisseur allant de 5 nm à 40 nm lorsque la couche de composé (24) est prévue sur la couche diélectrique (30).

11. Procédé de l'une quelconque des revendications 6 à 10, dans lequel la couche diélectrique (30) comprend WO₃, AlN, TiO₂, Al₂O₃, MgO, SiO₂, Si₃N₄, ou de l'oxyde d'indium et d'étain (ITO) ; et/ou
dans lequel la couche diélectrique a une épaisseur allant de 30 nm à 400 nm.
